# EUROPEAN PATENT SPECIFICATION

(11) **EP 1 729 175 B1**
(45) Date of publication and mention of the grant of the patent: **27.03.2013**
(21) Application number: 04807118.7
(22) Date of filing: 15.12.2004
(51) Int. Cl.: G03F 7/038, C08G 59/68, B41J 2/16, G03F 7/004

(54) **PHOTOSENSITIVE RESIN COMPOSITION AND METHOD OF FORMING PATTERN WITH THE COMPOSITION**
LICHTEMPFINDLICHE HARZZUSAMMENSETZUNG UND VERFAHREN ZUR ERZEUGUNG EINER STRUKTUR MIT DER ZUSAMMENSETZUNG
COMPOSITION À BASE DE RÉSINE PHOTOSENSIBLE ET PROCÉDÉ DE FORMATION D' UN MODÈLE AVEC LA COMPOSITION

(30) Priority: 26.03.2004 JP 2004093624
(43) Date of publication of application: 06.12.2006
(73) Proprietor: TOKYO OHKA KOGYO CO., LTD., Kawasaki-shi, Kanagawa 211-0012 (JP)
(72) Inventor: MAEDA, Hiroki, c/o TOKYO OHKA KOGYO CO., LTD., Kawasaki-shi, Kanagawa 2110012 (JP); TAKAHASHI, Toru, c/o TOKYO OHKA KOGYO CO., LTD., Kawasaki-shi, Kanagawa 2110012 (JP); KATSUMATA, Naoya, c/o TOKYO OHKA KOGYO CO., LTD., Kawasaki-shi, Kanagawa 2110012 (JP)
(74) Representative: HOFFMANN EITLE
(86) International application number: PCT/JP2004/018759
(87) International publication number: WO 2005/093514

(56) References cited:
- EP-A- 0 222 187
- EP-A1- 1 036 789
- EP-A2- 1 138 494
- WO-A1-03/018663
- JP-A- 2 279 718
- JP-A- 5 188 593
- JP-A- 9 268 205
- JP-A- 9 304 927
- JP-A- 9 325 491
- JP-A- 10 147 608
- JP-A- 11 323 094
- JP-A- 2000 186 071
- JP-A- 2001 209 178
- JP-A- 2001 274 849
- JP-A- 2001 348 482
- JP-A- 2003 073 457
- JP-A- 2003 238 691
- JP-A- 2003 238 691
- US-A1- 2002 076 651

## Description

### TECHNICAL FIELD

The present invention relates to a photosensitive resin composition and a method of forming a pattern using the composition, which enable one to form a minute resin by a resin pattern formation using a photolithographic technique. More specifically, the present invention relates to a photosensitive resin composition having high-sensitivity and high-resolution, which enables one to form 10 µm order of refined resin pattern, and a method of forming a pattern using the composition.

### BACKGROUND ART

Recently, by accompanying downsizing in a field of electronic parts, a need for photoresist, capable of forming "a resin pattern with several-tens of µm to several-hundreds of µm" with a high aspect ratio which enables to form refined resin, has arisen.

However, conventional photosensitive resin compositions containing a novolak resin and diazonaphthoquinone as a photoacid generator, were difficult to yield a profile of high aspect ratio to a thickness of several-hundreds of µm. This is because a diazonaphthoquinone type photoacid generator has a high absorption in the near-ultra violet region used in an exposure process, which brings a significant difference in exposure intensity between the top and bottom surfaces of a thick film, thereby resulting resin patterns having a tapered or distorted profile.

Against such a background, based on the discussions of photosensitive resin compositions containing the epoxy resin and an acid generator, photoresist capable of realizing a pattern profile with a high aspect ratio has been suggested.

This type of photoresist already reported include a photo-setting composition (Patent Document 1) composed of an epoxy-functional novolak resin, any of cation-generating photo-initiators such as triarylsulfonate, and a diluent capable of reacting to an epoxy functional group, the composition being completely photo-cured into one with a hard-to-peel property, and a photo-setting composition (Patent Document 2) composed of a multi-functional biphenol A formaldehyde-novolak resin, triphenylsulfonium hexafluoroantimonate which is an acid generator, and cyclopentanone which is a diluent, and allowing for thick film formation.

On the other hand, various kinds of acid generators other than diazonaphthoquinone type acid generators have been developed to provide a highly-sensitive resin composition for photo-shaping. One of these acid generators is, for example, an aromatic sulfonium cation polymerization initiator. For the photosensitive resin composition using any of these acid generators as an improving factor, for example, a resin composition (Patent Document 3) containing a cation polymerizing organic compound and an energy ray-sensitive cation polymerization initiator have been suggested.

Patent Document 1: Japanese Patent Publication No. 7-78628 B
Patent Document 2: United States Patent No. 6391523
Patent Document 3: Japanese Patent Application Laid-Open No. 9-268205 A

### DISCLOSURE OF THE INVENTION

However, such a problem has arisen that in conventional photosensitive resin compositions using a multi-functional epoxy resin such as novolak resin, contained cation initiator, for example, triphenylsulfonium hexafluoroantimonate has a low sensitivity. Therefore, it is necessary to include a large content of initiator to the resin composition, thereby reproducing a mask pattern inexactly onto a resin pattern.

In the aforementioned situation, an object of the present invention is to provide a photosensitive resin composition having high sensitivity, which allow for forming patterns having a high resolution, namely low shrinkage in volume during a heat-setting process and high aspect ratio profile, and a method of forming a pattern using the resin composition.

The inventors of the present invention have intensively conducted many experiments and discussions in improving the sensitivity and resolution of the photosensitive resin composition in order to achieve the aforementioned object. They successfully discovered that resin patterns having a high-sensitivity, a low shrinkage in volume during a heat-setting process and a high aspect ratio profile may be formed by combining a specific multi-functional epoxy resin and a specific acid generator to prepare a photosensitive resin composition and forming resin patterns using the photosensitive resin composition.

The present invention is based on the aforementioned knowledge, and the photosensitive resin composition according to the present invention comprises a multi-functional epoxy resin as defined in claim 1 and below and a cation polymerization initiator represented by the following general formula (1) shown below.

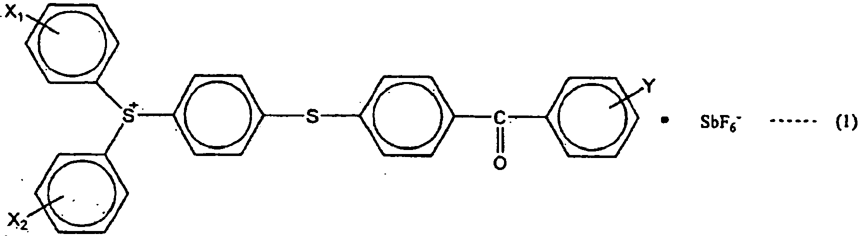

In general formula (1), X₁ and X₂ indicate any of a hydrogen atom, a halogen atom, a hydrocarbon group which may contain an oxygen atom or a halogen atom and an alkoxy group to which a substituent may bond, respectively, and they may be identical to or different from one another. Y indicates any of a hydrogen atom, a halogen atom, a hydrocarbon group which may contain an oxygen atom or a halogen atom and an alkoxy group to which a substituent bonds.

The aforementioned multi-functional epoxy resin is a multi- functional bisphenol A novolak epoxy resin, and the aforementioned cation polymerization initiator is desirably a compound represented by the following chemical formula (2) shown below.

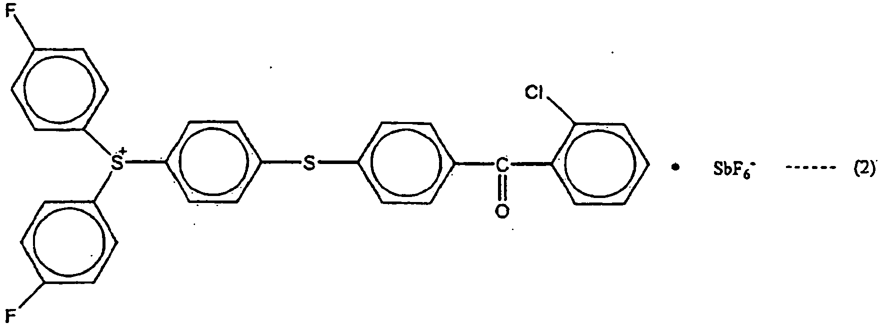

Moreover, the aforementioned photosensitive resin composition may contain a linear polymeric bifunctional epoxy resin as any other additives. Further, it may contain a naphthol type sensitizer. Furthermore, it may contain γ- butyrolactone as a solvent and may contain an oxetane and epoxy derivatives.

In addition, a photosensitive resin composition laminate according to the present invention is characterized in that at least one side, preferably both sides, of a photosensitive resin composition layer obtained from the photosensitive resin composition are protected with a protective film. The protection of at least one side of the photosensitive resin composition layer with the protective film allows the photosensitive resin composition laminate to be stored, for example, in the form of rolled sheet.

Namely, when being actually used, the photosensitive resin composition according to the present invention may be in the form of film (photosensitive resin composition laminate), wherein one or both sides of the photosensitive resin composition layer obtained from the photosensitive resin composition is protected with a resin film (protective film). Subsequently, cured resin patterns may be formed by attaching the photosensitive resin composition layer with the resin film(s) (protective film(s)) peeled away to a portion in which patterns to be formed, and then by applying the pattern exposure, development and heat-treatment processes.

In the case where a polyethylene terephthalate film is used for the resin film (protective film) to be attached on one side, the resin film (protective film) to be attached on the other side is preferably selected from the group consisting of a polyethylene terephthalate film, a polypropylene film and a polyethylene film.

Moreover, the method of forming a pattern according to the present invention is characterised in that it involves the processes of laminating the aforementioned photosensitive resin composition on a desired substrate, drying the photosensitive resin composition, exposing a radiation beam on the photosensitive resin composition layer to form given patterns, developing the beam-exposed resin composition, and heat-treating the resulting resin patterns to yield cured resin patterns of given shapes.

In the method of forming a pattern according to the present invention, to laminate the photosensitive resin composition on the desired substrate, the aforementioned film of photosensitive resin composition laminate may be attached on the substrate. Alternatively, solution of the photosensitive resin composition may be applied to the substrate and then dried.

### EFFECTS OF THE INVENTION

According to the photosensitive resin composition and the method of forming a pattern of the present invention, resin patterns with a high-sensitivity, a low shrinkage in volume during a heat-setting process and a high aspect ratio profile may be formed. This has such an effect that fine resin molding may be achieved at a favorable dimensional stability.

### BEST MODE FOR CARYING OUT THE INVENTION

Embodiments of the present invention will be explained below.
The present invention provides a photosensitive resin composition containing a sensitizer, a multi-functional epoxy resin defined in claim 1 and below and a cation polymerization initiator represented by the aforementioned general formula (1). A combination of the sensitizer, the multifunctional epoxy resin and the cation polymerization initiator allows for forming resin patterns with a high-sensitivity, a low shrinkage in volume during a heat-setting process and a high aspect ratio profile. Any of various combinations may be accepted and in particular, a combination of a 8-functional bisphenol A novolak epoxy resin (product name: "EPICOAT 157S70", supplied from Japan Epoxy Resin Co., Ltd) and 4-{4-(2-chlorobenzoyl) phenylthio}phenylbis(4-fluorophenyl)sulfonium hexafluoroantimonate (product name: ADEKA OPTOMER SP-172, supplied from ASAHI DENKA Co., Ltd) which is a compound represented by the aforementioned chemical formula (2), is most preferable, taking the effects to be achieved into consideration.

The aforementioned cation polymerization initiator, which causes cations to generate at a high efficiency when a radiation beam is irradiated, may be contained in a relatively small amount. The combination of the aforementioned cation polymerization initiator and the aforementioned multi-functional epoxy resin may vastly improve a sensitivity of the photosensitive resin composition. Moreover, it is suggested that the aforementioned cation polymerization initiator has the aforementioned favorable effects because it has a specific affinity to the aforementioned multi-functional epoxy resin, in particular, epoxy groups in molecules of the aforementioned multi-functional bisphenol A novolak epoxy resin, which may be efficiently catalyzed by the initiator thereby facilitating a polymerization. Further, by the aforementioned combination, an effect of a low shrinkage in volume during a heat-setting process of the photosensitive resin composition layer may be provided. Therefore, by using the photosensitive resin composition according to the present invention, it is possible to form a resin pattern having a high aspect ratio profile, not only a high-sensitivity, but also a low shrinkage in volume during a heat-setting process. As a result, an intended resin molding may be achieved at a high dimensional stability.

The multi-functional epoxy resin according to the present invention is an epoxy resins, which contain a sufficient number of epoxy groups in one molecule to form thick film patterns, and is a bisphenol A novolak epoxy resin, of which the functionality is 5-functional groups or more. In particular, a 8-functional bisphenol A novolak epoxy resin (product name: "EPICOAT 157570", supplied from Japan Epoxy Resin Co., Ltd.) and an average of 6.4-functional bisphenol A novolak epoxy resin (product name: "EPICLON N-885",supplied from DAINIPPON INK AND CHEMICALS INCORPORATED) are preferable.

The aforementioned multi-functional bisphenol A novolak epoxy resin is a resin represented by the following general formula (3) shown below.

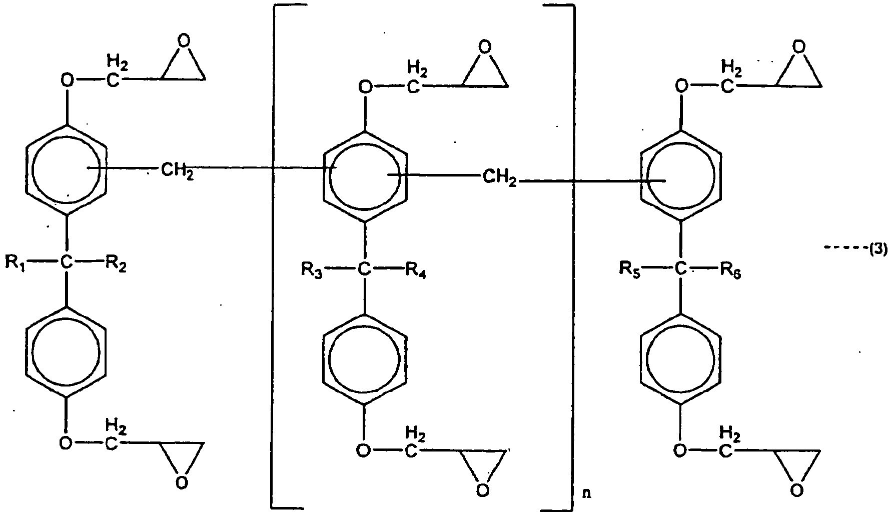

The epoxy group of the bisphenol A novolak epoxy resin represented by the aforementioned general formula (3) may be either a bisphenol A epoxy resin or a polymer polymerized with a bisphenol A novolak epoxy resin. In the aforementioned general formula (3), R₁ to R₆ are independently H or CH₃, respectively. "n" indicates a 0 (zero) or larger integer, which represents a repeating unit.

A softening point of the aforementioned multi-functional epoxy resin is not specifically limited as far as it remains in a solid form at an ordinary temperature. In a case of forming a dry film resist, since softening at a temperature (approximately 40 °c) near an ordinary temperature is not preferable, it must be softened by heating in a laminating process. From this standpoint, the softening point of the aforementioned multi-functional epoxy resin is preferably 50 to 100 °c, more preferably 60 to 80 °c.

If a composition ratio of the aforementioned multi-functional epoxy resin in the photosensitive resin composition is too high, the composition coated on a substrate has a lower sensitivity, leading to failure to endure actual use. On the contrary, a too low composition ratio is not preferable because a resulting cured coating film may be brittle. From this standpoint, the aforementioned composition ratio is preferably 80 to 99.9%, more preferably 92 to 99.4%.

The cation polymerization initiator according to the present invention is a compound for generating cations when the compound being irradiated by any of radiation beams including an ultra violet ray beam, a far ultra-violet beam, any of excimer laser beams such as KrF and ArF, a X-ray beam and an electron beam, and the generated cations can be act as a polymerization initiator.

The aforementioned cation polymerization initiator is a compound represented by general formula (1) shown below.

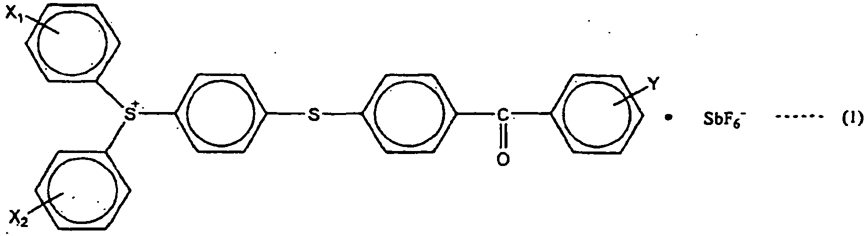

In the aforementioned general formula (1), X₁ and X₂ indicate any of a hydrogen atom, a halogen atom, a hydrocarbon group which may contain an oxygen atom or a halogen atom or an alkoxy group to which a substituent may bond, respectively, and they may be identical to or different from one another. The X₁ and X₂ are preferably halogen atoms, among them, more preferably fluorine atoms among halogen atoms.

In the aforementioned general formula (1), Y indicates a hydrogen atom, a halogen atom, a hydrocarbon group which may contain an oxygen atom or a halogen atom or an alkoxy group to which a substituent may bond. The aforementioned Y is preferably a halogen atom among them, more preferably a chlorine atom among halogen atoms.

The aforementioned cation polymerization initiator includes, for example, 4-(4-benzoylphenylthio)phenyldiphenyl sulfoniumhexafluoroantimonate,
4-(4-benzoylphenylthio)phenylbis(4-hydroxyethyloxyphenyl)su lfoniumhexafluoroantimonate,
4-(4-benzoylphenylthio)phenylbis(4-fluorophenyl)sulfoniumhe xafluoroantimonate,
4-(4-benzoylphenylthio)phenylbis(4-chlorophenyl)sulfonium hexafluoroantimonate,
4-{4-(2-chlorobenzoyl)phenylthio}phenylbis(4-fluorophenyl)s ulfoniumhexafluoroantimonate,
4-{4-(3-chlorobenzoyl)phenylthio}phenylbis(4-fluorophenyl)s ulfoniumhexafluoroantimonate,
4-(4-benzoylphenylthio)phenylbis(4-methylphenyl)sulfoniumhe xafluoroantimonate,
4-(4-benzoylphenylthio)phenylbis(4-hydroxyethylphenyl)sulfo niumhexafluoroantimonate,
4-{4-(4-hydroxyethyloxybenzoyl)phenylthio}phenylbis(4-fluor ophenyl)sulfoniumhexafluoroantimonate,
4-{4-(4-hydroxyethyloxybenzoyl)phenylthio}phenyldiphenylsul foniumhexafluoroantimonate,
4-{4-(4-hydroxyethyloxybenzoyl)phenylthio}phenylbis(4-hydro xyethyloxyphenyl)sulfoniumhexafluoroantimonate, 4-(4-benzoylphenylthio)phenylbis(4-methoxyethoxyphenyl)sulf oniumhexafluoroantimonate,
4-{4-(3-methoxybenzoyl)phenylthio}phenyldiphenylsulfoniumhe xafluoroantimonate,
4-{4-(3-methoxycarbonylbenzoyl)phenylthio}phenyldiphenylsul foniumhexafluoroantimonate,
4-{4-(2-hydroxymethylbenzoyl)phenylthio}phenyldiphenylsulfo niumhexafluoroantimonate,
4-{4-(4-methylbenzoyl)phenylthio}phenylbis(4-fluorophenyl)s ulfoniumhexafluoroantimonate,
4-{4-(4-methoxybenzoyl)phenylthio}phenylbis(4-fluorophenyl) sulfoniumhexafluoroantimonate,
4-{4-(4-fluorobenzoyl)phenylthio}phenylbis(4-fluorophenyl)s ulfoniumhexafluoroantimonate, and
4-{4-(2-methoxycarbonylbenzoyl)phenylthio}phenylbis(4-fluor ophenyl)sulfoniumhexafluoroantimonate. Among these compounds,
4-(4-benzoylphenylthio)phenyldiphenylsulfoniumhexafluoroant imonate,
4-(4-benzoylphenylthio)phenylbis(4-hydroxyethyloxyphenyl)su lfoniumhexafluoroantimonate,
4-(4-benzoylphenylthio)phenylbis(4-fluorophenyl)sulfoniumhe xafluoroantimonate,
4-(4-benzoylphenylthio)phenylbis(4-chlorophenyl)sulfoniumhe xafluoroantimonate, or
4-{4-(3-chlorobenzoyl)phenylthio}phenylbis(4-fluorophenyl)s ulfoniumhexafluoroantimonate is more preferable and
4-{4-(2-chlorobenzoyl)phenylthio}phenylbis(4-fluorophenyl)s ulfoniumhexafluoroantimonate (product name: "ADEKA OPTPMER SP-172", Asahi Denka Kogyo KK) represented by chemical formula (2) shown below is most preferable.

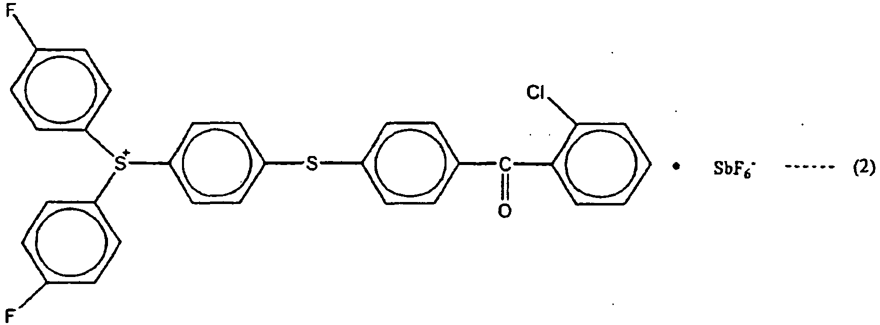

A too high constitutive percentage of the aforementioned cation polymerization initiator in the aforementioned photosensitive resin composition is not preferable because the aforementioned polymeric composition is difficult to be developed. On the contrast, a too low percentage is not also preferable because a longer time is required for curing the aforementioned polymeric composition by exposing a radiation beam. Taking these points into consideration, the aforementioned constitutive percentage is preferably 0.1 to 10%, more preferably 0.5 to 5%.

The aforementioned photosensitive resin composition may further contain a linear polymeric 2-functional epoxy resin for improving its film-forming performance.

The aforementioned linear polymeric 2-functional epoxy resin is preferably a resin represented by general formula (4) shown below.

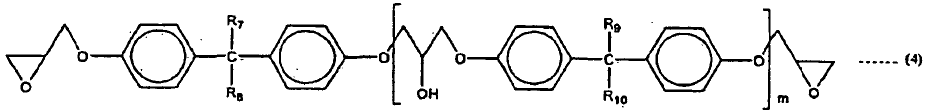

The aforementioned general formula (4), R₇ to R₁₀ are H or CH₃, respectively. "m" is a 0 (zero) or larger integer, which expresses the number of a repeating unit.

The aforementioned linear polymeric 2-functional epoxy resin is not specifically limited and any of those, which is polymerized with a bisphenol A epoxy or a bisphenol F epoxy and have any weight-average molecular weight preferably ranging from 2000 to 7000 is preferable and any of those, which have any weight-average molecular weight ranging from 3000 to 5000 is more preferable. In the case of the linear polymeric 2-functional epoxy resins having a weight-average molecular weight of 2000 or smaller, their film-forming performance is not improved, while those having a weight-average molecular weight of 7000 or larger are not fused together with any multi-functional epoxy resin. Specifically, a bisphenol A epoxy resin (product name: "EPICOAT 1009", a weight-average molecular weight 3759, Japan Epoxy Resin Co., Ltd.) is in particular preferable. Note that the weight-average molecular weight may be determined by gel permeation chromatography.

The aforementioned photosensitive resin composition further contains a naphthol sensitizer. A too high sensitivity of the photosensitive resin composition may make the dimensions of resulting resin patterns thicker than those of a mask when a radiation beam is irradiated with a space between them. Such an increase in thickness may be controlled at no cost of its sensitivity by containing the naphthol sensitizer. Thus, the addition of the naphthol sensitizer is preferable because any error occurring between the dimensions of the mask and resist patterns may be controlled.

The aforementioned naphthol sensitizer includes, for example, 1-naphthol, β-naphthol, α-naphthol methylether, and α-naphthol ethylether. Taking an effect of controlling an increase in thickness of the aforementioned resist at no cost of its sensitivity, among them, 1-nephthol is most preferable.

A too high constitutive percentage of the naphthol sensitizer in the aforementioned photosensitive resin composition is not preferable because the resulting patterns have inversely-tapered shapes and their line widths are too thin. Taking this point into consideration, the aforementioned constitutive percentage is preferably 0 to 10%, more preferably 0.1 to 3%.

The aforementioned photosensistive polymeric composition may further contain a solvent. Containing the solvent may improve the sensitivity of the photosensitive resin composition. This type of solvents include, for example, propyleneglycolmonomethyletheracetate (hereinafter, simply referred to as "PGMEA"), methylisobutylketone (hereinafter, simply referred to as "MIBK"), butylacetate, methylamylketone (2-heptanone), ethyl acetate, and methylethylketone (hereinafter, simply referred to as "MEK").

In the case where a liquid resist is used among the aforementioned solvents, γ-butyrolactone is preferable because it reacts to and is incorporated into the resist. In the case of a dry resist, PGMEA, MIBK, butylacetate, or MEK is preferable because any of them has superior wettability with a base film and surface tension.

The aforementioned photosensitive resin composition may further contain oxetane and epoxy derivatives. In the case where a dry film resist is formed, containing the oxetane and epoxy derivatives may increase flexibility of the photosensitive resin composition being not yet cured at no cost of the physical properties of the cured photosensitive resin composition. This type of oxetane derivatives are not specifically limited and specifically include, for example, 3-ethyl-3hydroxymethyloxetane, 1,4-bis[[(3-ethyl-3-oxetanyl)methoxy]methyl]benzene, and di[1-ethyl(3-oxetanyl)]methylether. These epoxy derivatives include the bisphenol A epoxy resin and the bisphenol F epoxy resin, both of which have a weight-average molecular weight of 7000 or smaller, preferably 2000 or smaller, more preferably 1000 or smaller. Specifically, the bisphenol A epoxy resin (product name: "EPICOAT 828", a weight-average molecular weight 380, Japan Epoxy Resin Co., Ltd.) may be given as an example. Note that the weight-average molecular weight may be determined by gel permeation chromatography.

The photosensitive resin composition of the present invention may further contain a commonly used miscible additive (s), for example, a resin, an elasticizer, a colorant, and a surfactant, if desired, to improve the performance of resulting patterns.

In actual applications, the photosensitive resin composition of the present invention may be used as a cured film by applying its solution, or a dry film (photosensitive resin composition laminate), of which at least one side, preferably both sides of a photosensitive resin composition layer made of the photosensitive resin composition is protected with a resin film (protective film), is formed so that it may be attached on a desired base prior to pattern exposure. In the case where a polyethylene terephthalate film is applied to one side of the photosensitive resin composition layer made of the photosensitive resin composition as the aforementioned resin film (protective film), any polymeric film of polyethylene terephthalate film, polypropylene film, and polyethylene film is preferably used as the protective film on the other side.

As mentioned above, by providing the photosensitive resin composition as a film (photosensitive resin composition laminate), the processes for applying it on the base and drying it may be omitted, allowing for easier pattern formation using the photosensitive resin composition of the present invention.

The photosensitive resin composition of the present invention is dissolved in a solvent, applied on the desired base, namely, any of substrates such as silicon wafer and then dried to form a photosensitive resin composition layer, that layer being exposed to a radiation beam for patterning, and then treated with a developing solution. By following these processes, favorable resin patterns, which exactly reflect the mask patterns, may be formed independently of the base to be used. The resulting resin patterns may be heat-treated to yield given shapes of cured resin patterns.

Alternatively, by forming the photosensitive resin composition into a dry film (photosensitive resin composition laminate), peeling away the protective film from the aforementioned dry film (photosensitive resin composition laminate) and then attaching it on the desired base, exposing a radiation beam on the resulting photosensitive resin composition layer, and developing it with a developing solution, favorable resin patterns, which exactly reflect mask patterns, may be formed independently of the base to be used. This method allows for fine resin formation at a superior dimensional stability necessary for forming electronic devices, for example, an ink jet and a recording head. The resulting resin patterns can be heat-treated to yield given shapes of cured resin patterns.

### EXAMPLES

Now, preferred embodiments of the present invention are in detail described. The embodiments given herein are intended to provide informative examples for suitably illustrating the present invention and not intended to limit the present invention.

### [Photosensitive resin composition]

### (Examples 1 to 6, Comparative Examples 1 to 5 wherein example 1 does not fall under the claimed invention)

By mixing a multi-functional epoxy resin, an initiator, and any other component (s) based on a composition (parts by mass for a unit) listed in Table 1 shown below, a photosensitive composition was prepared.

Note that in Table 1, A-1, A-2, B-1 to B-4, C, D-1, D-2, E-1, E-2, F and G indicate substances listed below, respectively.
(A-1): Multi-functional bisphenol A novolak epoxy resin (product name: "EPICOAT 157S70", Japan Epoxy Resin Co., Ltd.)
(A-2) : Multi-functional bisphenol A novolak epoxy resin (product name: "EPICLONE N-885", DAINIPPON INK AND CHEMICALS INCORPORATED)
(B-1): Cation polymerization initiator (product name: "ADEKA OPTOMER SP-172", Asahi Denka Kogyo KK)
(B-2): 4-phenylthiophenyldiphenylsulfoniumhexafluoroantimonate
(B-3) : 4,4-bis[di(β-hydroxyethoxy)phenylsulfonio]phenylsulfide-bis -hexafuloroantimonate (product name: "ADEKA OPTOMER SP-170", Asahi Denka Kogyo KK)
(B-4): Iodonium PF 6-salt initiator (product name: "WPI-003, WAKO Pure Chemical Industries, Ltd.)
(C): Polymeric 2-functional epoxy resin (product name: "EPICOAT 1009", Japan Epoxy Resin Co., Ltd.)
(D-1): Sensitizer, 1-naphthol
(D-2): Sensitizer, dibutylanthracene
(E-1): Solvent, γ-butyllactone
(E-2): Solvent, MIBK
(F): Oxetane derivative, 1,4-bis{[(3-ethyl-3-oxetanyl)methoxy]methyl}benzene
(G) : Levelling agent (product name: PAINTADM, Dow Corning Corporation)

### [Patterning of photosensitive resin composition]

### (Examples 1 to 4, Comparative Examples 1 to 5)

The resulting photosensitive resin composition was applied on a silicon wafer using a spin coater and then dried to yield a photosensitive resin composition layer with a film thickness of 30µm. The photosensitive resin composition layer was pre-baked on a hot plate at 60 °c for five minutes and then at 90 °c for five minutes. Then, a parallel light aligner (mask aligner, producted by Canon Inc.) was used to apply pattern exposure (proximity, GHI ray beam), the beam-exposed layer was heated (PEB) on the hot plate at 90 °c for five minutes, and subjected to the development process by maceration using PGMEA for four minutes. Then, the developed resin patterns formed on the substrate were together post-baked in an oven at 200 °c for one hour to yield the cured resin patterns on the substrate.

### [Patterning of photosensitive resin composition]

### (Examples 5 to 6)

The resulting photosensitive resin composition was uniformly applied on a polyethyleneterephtalate (PET) film (support film, Teijin Ltd.) with a film thickness of 38µm with a molding lubricant, and dried at 65 °c for five minutes and then at 80 °c for five minutes in a hot-air convection drier. Then, the PET (protective film) with a film thickness of 25µm with the molding lubricant applied was laminated on an exposed surface of the photosensitive resin composition to form a dry film resist (hereinafter, simply referred to as "DFR") having a photosensitive resin composition layer with a film thickness of 30µm.

The DFR, after its protective film was peeled away, was laminated on the silicon wafer under the conditions, a roll temperature of 80 °c, an air-pressure of 2 kg/cm² and a deposition rate of 0.5 m/min to yield the photosensitive resin composition layer. On the photosensitive resin composition layer, pattern exposure (proximity, GHI ray beam) was applied using the parallel light aligner (mask aligner, Canon Inc.). Subsequently, it was PEB-treated on the hot plate at 90 °c for five minutes and subjected to the development process by maceration using PGMEA for four minutes. Finally, the developed resin patterns were post-baked in the oven at 200 °c for one hour to yield the cured resin patterns on the substrate.

### [Evaluation of the photosensitive resin composition]

After the development process, required exposure amount for the aforementioned photosensitive resin composition layers were evaluated as follows. The result from the evaluation was summarized in Table 1 shown below.
Note that in Table 1, "exposure amount" indicates the required exposure amount and "thin wire adherence" indicates a highest-density wire width within the formed resist patterns (an average wire width in the case where the radiation beam is irradiated on the aforementioned photosensitive resin composition layer through the mask with a wire width of 6µm). The thin wire adherence parameter was evaluated only for Examples 1 and 2. Heat shrinkage (%) during a post-baking process is a ratio in dimension (shrinkage) between the patterns before and after the post-baking process.

**Table 1**

| | Com pon ent | Example | | | | | | Comparative Example | | | | |
|---|---|---|---|---|---|---|---|---|---|---|---|---|
| | | 1 | 2 | 3 | 4 | 5 | 6 | 1 | 2 | 3 | 4 | 5 |
| Multi-func tional epoxy resin | A-1 | 100 | 100 | - | 80 | 100 | 90 | 100 | 100 | 100 | 100 | 100 |
| | A-2 | - | - | 100 | - | - | - | - | - | - | - | - |
| Initiator | B-1 | 3 | 3 | 3 | 3 | 3 | 3 | - | - | - | - | - |
| | B-2 | - | - | - | - | - | - | 3 | 20 | - | - | - |
| | B-3 | - | - | - | - | - | - | - | - | 3 | 3 | 3 |
| | B-4 | - | - | - | - | - | - | - | - | - | - | 3 |
| Polymeric epoxy resin | C | - | - | - | 20 | - | - | - | | - | - | - |
| Sensitizer | D-1 | - | 1 | 1 | 1 | 1 | 1 | - | - | - | - | - |
| | D-2 | | - | - | - | - | - | - | 1 | - | 1 | 1 |
| Solvent | E-1 | 50 | 50 | 50 | 50 | - | - | 50 | 50 | 50 | 50 | 50 |
| | E-2 | - | - | - | - | 50 | 50 | - | - | - | - | - |
| Others | F | - | - | - | - | - | 10 | - | - | - | - | - |
| | G | - | - | - | - | 1 | 1 | - | - | - | - | - |
| Exposure amount (mJ) | | 300 | 300 | 300 | 300 | 300 | 300 | 600 | 300 | 600 | 500 | 500 |
| Thin wire adherence (µm) | | 4 | 4 | 4 | 4 | 4 | 4 | 10 | 6 | 10 | 6 | 6 |
| Wire width (µm) | | 8 | 7 | 7 | - | - | - | - | - | - | - | |
| Heat shrinkage during post-baking (%) | | <1 | <1 | <1 | <1 | <1 | <1 | 6 | 6 | <1 | <1 | 8 |

As known from Table 1, favorable results were observed in Examples 1 to 6. In Example 2, it was demonstrated that the addition of 1-naphthol allowed an increase in resist thickness to be controlled at no cost of its sensitivity. On the other hand, at least two of values for "required exposure amount", "thin wire adherence" and "heat shrinkage" in the Comparative Examples were larger than those in the Examples.

Based on the result shown in Table 1, it was verified that by combining the multi-functional epoxy resin and the cation polymerization initiator, resin patterns with a high sensitivity and a low shrinkage in volume during heat-setting and having a high aspect ratio profile might be yielded. Although an increased sensitivity may make the dimension of the resist pattern thicker than that of the mask when a radiation beam is irradiated with a space between them, it was also verified that the addition of the naphthol sensitizer might control an increase in resist thickness at no cost of its sensitivity.

### INDUSTRIAL APPLICABILITY

As mentioned above, the photosensitive resin composition according to the present invention is useful in forming resin patterns having a high aspect ratio profile and in particular, suitable for forming resin patterns with a high dimensional stability for, for example, microscopic sizes of electronic devices.

## Claims

1. A photosensitive resin composition comprising:
a naphthol sensitizer;
a multi-functional bisphenol A novolak epoxy resin, the functionality of which is 5-functional groups or more and which is represented by the general formula (3) shown below: 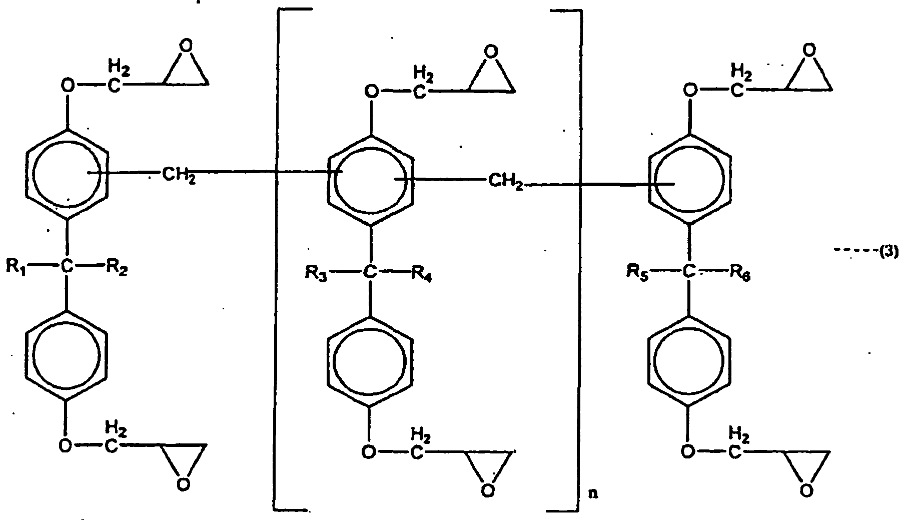
in the formula, R₁ to R₆ are independently H or CH₃, respectively, n indicates zero or larger integer ; and
a cationic polymerization initiator represented by the general formula (1) shown below: 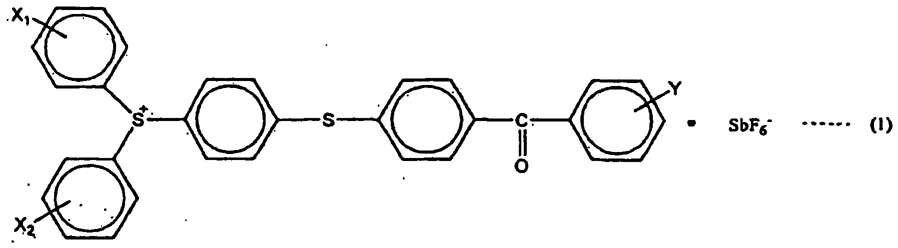
in the formula, X₁ and X₂ indicate a hydrogen atom, a halogen atom, a hydrocarbon group which may contain an oxygen atom or a halogen atom, or an alkoxy group to which a substituent may bond, respectively, and they may be identical to or different from one another, and Y indicates a hydrogen atom, a halogen atom, a hydrocarbon group which may contain an oxygen atom or a halogen atom, or an alkoxy group to which a substituent may bond.

2. The photosensitive resin composition according to claim 1, wherein the cationic polymerization initiator is a compound represented by the chemical formula (2) shown below:

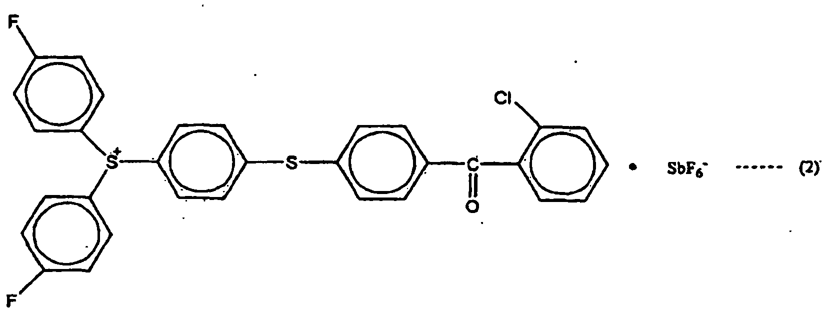

3. The photosensitive resin composition according to claim 1, further comprising a linear polymeric 2-functional epoxy resin.

4. The photosensitive resin composition according to claim 1, further comprising γ-butyrolactone.

5. A photosensitive resin composition laminate comprising:
a photosensitive resin composition layer obtained from the photosensitive resin composition according to claim 1; and
a protective film,
wherein at least one side of the photosensitive resin composition layer is protected with the protective film.

6. A method of forming a pattern comprising the steps of:
applying the photosensitive resin composition according to claim 1 on a desired base and then drying the photosensitive resin composition;
exposing the photosensitive resin composition layer to a radiation beam to form the given resin patterns;
developing the beam-exposed photosensitive resin composition layer; and
heat-treating the resulting resin patterns to yield cured resin patterns of given shapes.

7. A method of forming a pattern comprising the steps of:
peeling the protective film away from the photosensitive resin composition laminate according to claim 5;
attaching the resulting photosensitive resin composition layer on a desired base;
exposing the photosensitive resin composition layer to a radiation beam to form a given pattern;
developing the beam-exposed photosensitive resin composition layer; and
heat-treating the resulting resin patterns to yield cured resin patterns of given shapes.

8. The photosensitive resin composition according to claim 1, wherein the content of the multi-functional bisphenol A novolak epoxy resin, the functionality of which is 5-functional groups or more is 80 to 99.9 mass% based on a solid content of the photosensitive resin composition.

## Patentansprüche

1. Lichtempfindliche Harzzusammensetzung, umfassend:
einen Naphthol-Sensibilisator;
ein multifunktionales Bisphenol A-Novolak-Epoxyharz, das eine Funktionalität von 5 funktionellen Gruppen oder mehr aufweist und durch die unten gezeigte allgemeine Formel (3) dargestellt wird: 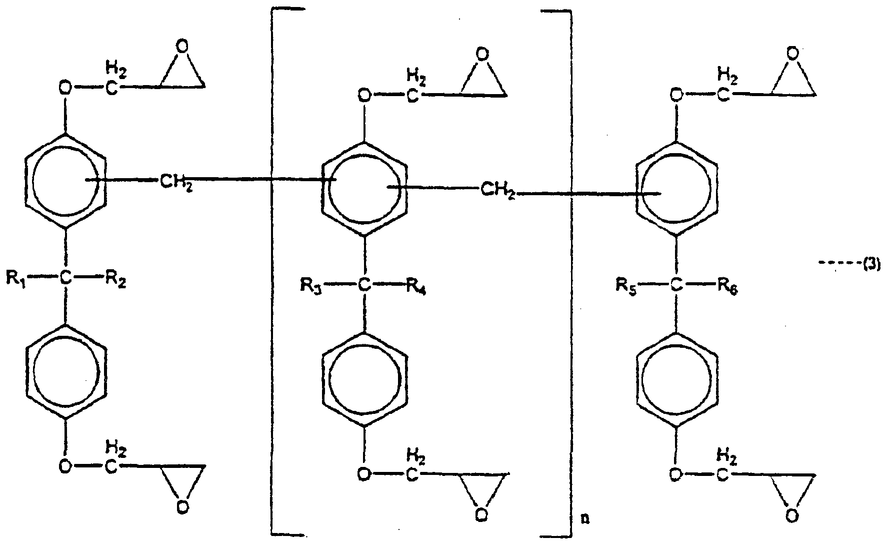
worin in der Formel R₁ bis R₆ unabhängig voneinander H oder CH₃ sind, n 0 oder eine größere ganze Zahl angibt; und
einen kationischen Polymerisationsinitiator der unten gezeigten allgemeinen Formel (1): 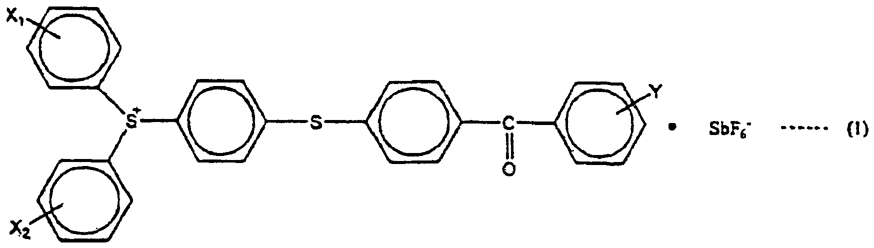
worin in der Formel X₁ und X₂ ein Wasserstoffatom, ein Halogenatom, eine Kohlenwasserstoffgruppe, die ein Sauerstoffatom oder ein Halogenatom enthalten kann, oder eine Alkoxygruppe, an die ein Substituent gebunden sein kann, darstellen und sie gleich oder unterschiedlich voneinander sein können, und Y ein Wasserstoffatom, ein Halogenatom, eine Kohlenwasserstoffgruppe, die ein Sauerstoffatom oder Halogenatom enthalten kann oder eine Alkoxygruppe, an der ein Substituent gebunden sein kann, darstellt.

2. Lichtempfindliche Harzzusammensetzung gemäß Anspruch 1, worin der kationische Polymerisationsinitiator eine Verbindung der unten gezeigten Formel (2) ist:

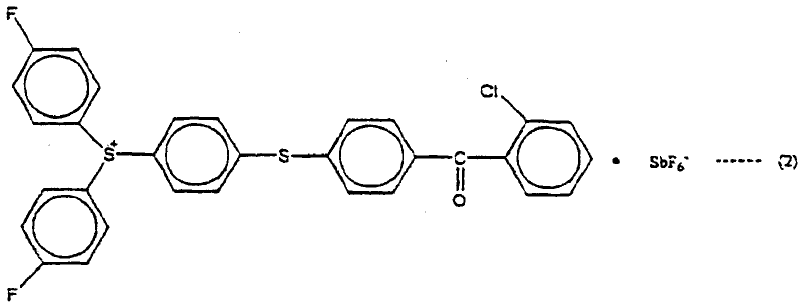

3. Lichtempfindliche Harzzusammensetzung gemäß Anspruch 1, die weiterhin ein lineares polymeres 2-funktionelles Epoxyharz umfasst.

4. Lichtempfindliche Harzzusammensetzung gemäß Anspruch 1, die weiterhin γ-Butyrolacton umfasst.

5. Lichtempfindliches Harzzusammensetzungslaminat, umfassend:
eine Schicht einer lichtempfindlichen Harzzusammensetzung, die aus der lichtempfindlichen Harzzusammensetzung gemäß Anspruch 1 erhalten wird; und
einen Schutzfilm, worin zumindestens eine Seite der Schicht der lichtempfindlichen Harzzusammensetzung mit dem Schutzfilm geschützt ist.

6. Verfahren zum Bilden einer Struktur, umfassend die Schritte:
Aufbringen der lichtempfindlichen Harzzusammensetzung gemäß Anspruch 1 auf eine gewünschte Basis und dann Trocknen der lichtempfindlichen Harzzusammensetzung;
Bestrahlen der Schicht der lichtempfindlichen Harzzusammensetzung mit einem Strahl, um die gegebenen Harzstrukturen zu bilden;
Entwickeln der bestrahlten Schicht der lichtempfindlichen Harzzusammensetzung; und
Wärmebehandeln der resultierenden Harzstrukturen, um gehärtete Harzstrukturen gegebener Formen zu erhalten.

7. Verfahren zum Bilden einer Struktur, umfassend die Schritte:
Ablösen des Schutzfilms aus dem lichtempfindlichen Harzzusammensetzungslaminat gemäß Anspruch 5;
Anheften der resultierenden Schicht der lichtempfindlichen Harzzusammensetzung auf eine gewünschte Basis;
Bestrahlen der Schicht der lichtempfindlichen Harzzusammensetzung mit einem Strahl, um die gegebenen Harzstrukturen zu bilden;
Entwickeln der bestrahlten Schicht der lichtempfindlichen Harzzusammensetzung; und
Wärmebehandeln der resultierenden Harzstrukturen, um gehärtete Harzstrukturen gegebener Formen zu erhalten.

8. Lichtempfindliche Harzzusammensetzung gemäß Anspruch 1, worin der Gehalt des multifunktionellen Bisphenol A-Novolak-Epoxyharzes, das eine Funktionalität von 5 funktionellen Gruppen oder mehr hat, 80 bis 99,9 Massen% auf Basis eines Feststoffgehalts der lichtempfindlichen Harzzusammensetzung ist.

## Revendications

1. Composition de résine photosensible comprenant :
un sensibilisant naphtol ;
une résine multifonctionnelle de bisphénol A-Novolaque-époxy, la fonctionnalité de laquelle est des groupes penta-fonctionnels ou plus et qui est représentée par la formule générale (3) montrée ci-dessous : 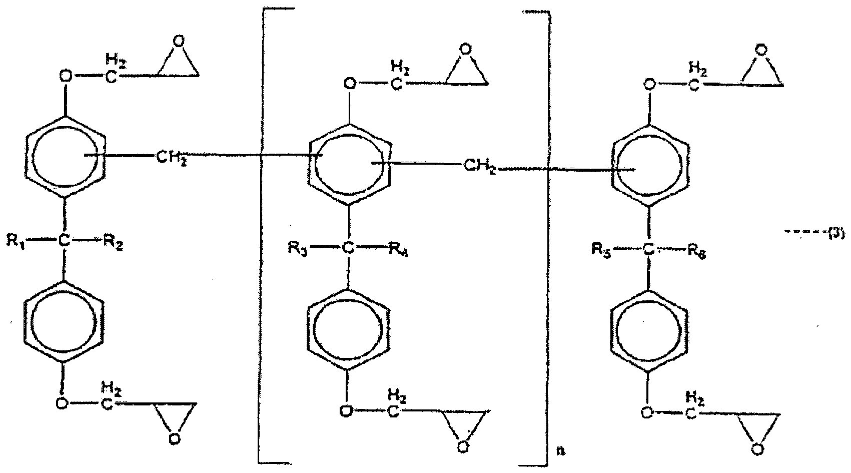
dans la formule, R₁ à R₆ sont indépendamment H ou CH₃, respectivement, n indique zéro ou un entier plus grand ; et
un initiateur de polymérisation cationique représenté par la formule générale (1) montrée ci-dessous : 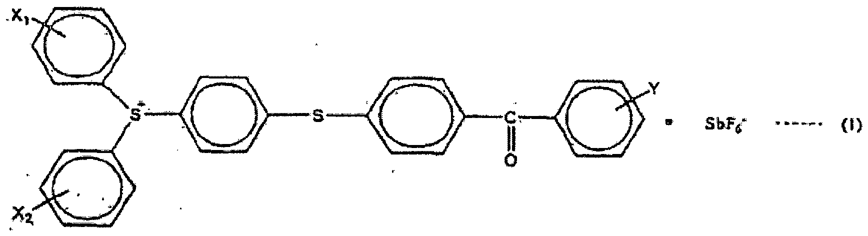
dans la formule, X₁ et X₂ indiquent un atome d'hydrogène, un atome d'halogène, un groupe hydrocarbure qui peut contenir un atome d'oxygène ou un atome d'halogène, ou un groupe alcoxy auquel un substituant peut se lier, respectivement, et ils peuvent être identiques ou différents l'un de l'autre, et Y indique un atome d'hydrogène, un atome d'halogène, un groupe hydrocarbure qui peut contenir un atome d'oxygène ou un atome d'halogène, ou un groupe alcoxy auquel un substituant peut se lier.

2. Composition de résine photosensible selon la revendication 1, dans laquelle l'initiateur de polymérisation cationique est un composé représenté par la formule chimique (2) montrée ci-dessous :

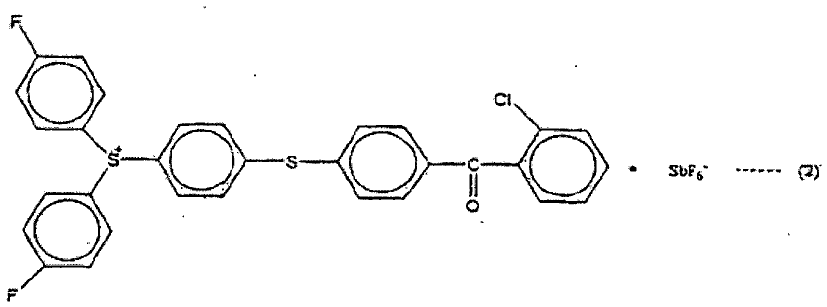

3. Composition de résine photosensible selon la revendication 1, comprenant en outre une résine époxy bi-fonctionnelle polymérique linéaire.

4. Composition de résine photosensible selon la revendication 1, comprenant en outre de la γ-butyrolactone.

5. Stratifié d'une composition de résine photosensible comprenant :
une couche de composition de résine photosensible obtenue à partir de la composition de résine photosensible selon la revendication 1 ; et
un film protecteur,
dans lequel au moins un côté de la couche de composition de résine photosensible est protégé avec le film protecteur.

6. Procédé de formation d'un motif comprenant les étapes de :
application de la composition de résine photosensible selon la revendication 1 sur une base désirée et ensuite séchage de la composition de résine photosensible ;
exposition de la couche de composition de résine photosensible à un faisceau de rayonnement pour former les motifs de résine donnés ;
révélation de la couche de composition de résine photosensible exposée au faisceau ; et
traitement à la chaleur des motifs de résine résultants pour donner des motifs de résine durcis de formes données.

7. Procédé de formation d'un motif comprenant les étapes de :
pelage du film protecteur du stratifié de composition de résine photosensible selon la revendication 5 ;
fixation de la couche de composition de résine photosensible résultante sur une base désirée ;
exposition de la couche de composition de résine photosensible à un faisceau de rayonnement pour former un motif donné ;
révélation de la couche de composition de résine photosensible exposée au faisceau ; et
traitement à la chaleur des motifs de résine résultants pour donner des motifs de résine durcis de formes données.

8. Composition de résine photosensible selon la revendication 1, dans laquelle la teneur de la résine multifonctionnelle de bisphénol A-Novolaque-époxy, la fonctionnalité de laquelle est des groupes penta-fonctionnels ou plus, est 80 à 99,9% en masse sur la base d'une teneur en solides de la composition de résine photosensible.
